# EUROPEAN PATENT SPECIFICATION

(11) **EP 1 431 766 B1**
(45) Date of publication and mention of the grant of the patent: **24.08.2005**
(21) Application number: 03468010.8
(22) Date of filing: 15.12.2003
(51) Int. Cl.: G01R 11/24, G01F 15/00, G08B 13/08

(54) **Casing adapted to detect any opening of the casing**
Gehäuse mit Detektierung ob das Gehäuse geöffnet ist
Boitier adapté à détecter toute ouverture du boitier

(30) Priority: 16.12.2002 SI 200200302
(43) Date of publication of application: 23.06.2004
(73) Proprietor: Iskraemeco, Merjenje in Upravljanje Energije, D.D., 4000 Kranj (SI)
(72) Inventor: Krsnik, Zoran, 4203 Duplje (SI); Thaler, Matjaz, 4000 Kranj (SI); Stimac, Peter, 4220 Skofja Loka (SI); Pogacnik, Janez, 4244 Podnart (SI); Dolzam, Bostjan, 4000 Kranj (SI); Vrbica, Milan, 1215 Medvode (SI)
(74) Representative: Primozic, Alenka

(56) References cited:
- EP-A- 0 965 848
- GB-A- 848 506
- US-A- 4 588 949
- PATENT ABSTRACTS OF JAPAN 2003296827 A (MATSUSHITA ELECTRIC WORKS LTD), 17 October 2003 (2003-10-17) & JP 2003 296827 A 17 October 2003 (2003-10-17)

## Description

### Object of invention

The invention relates to a casing adapted to detect any opening and the detected opening of which is preferably reported to a supervisor. In all cases each opening of the casing is stored in a non-volatile memory. The casing of the invention could for instance be used as a casing of an electricity meter, because each unauthorized opening should be recorded in order to establish unauthorized use.

### Technical problem

The technical problem of the invention lies in that a casing is proposed, which is cheap and simply adapted to detect any opening, whereat such detection remains stored or can be reported to a remote location.

A calculation device like for instance an electricity meter must be provided with a protection means like a sealing screw preventing the casing from being opened. Preferably, the casing of such device is additionally adapted to detect any unauthorized opening and, if an opening takes place, to immediately report it to a supervisory location.

### Prior art

The patent EP 0 447 615 describes a casing provided with a magnetized ferrite ring and a permanent magnet. When the casing is being opened, the ring and the magnet move one past another and the ferrite ring thus get remagnetized. This solution calls for an expensive and complicated structure to protect the ferrite ring against the influence of any external magnetic field.

A casing with switches positioned below the screws for the fastening of the casing is described in WO 97/09623. The opening of the casing is only detected if a supply voltage is present.

The patent US 6,054,930 describes an electro-mechanical element, for which both parts of the casing are specially manufactured and which requires a permanent power supply with a relatively high energy consumption.

The patent EP 0 549 519 discloses a technical solution, according to which a handle arranged on the screw for closing the casing triggers a stroke on a quartz crystal when the handle is unscrewing the screw. Mechanically, this is a very demanding solution. Electric pulses are stored in a memory if the device in the casing is connected to power supply.

There are two more technical solutions (FR 2 681 134 and EP 0 965 848) with a screw for closing the casing being in connection with a resistance layer. Both solutions are mechanically demanding.

The patent EP 0 965 848 describes a detection of the opening of a casing carried out by means of a toothed wheel and a code switch. After a certain number of openings, the signals of the switch recur and the opening may remain unrecognizable.

### Solution to the technical problem

The mentioned technical problem is solved by a casing adapted to detect any opening, which is characterized in that on a first part of the casing an armature containing a rotatable wheel is arranged, said wheel, when the first part of the casing is being opened, rolling along a second part of the casing and in that a means acts on the wheel, said means performing a different torque when rotating in one direction than in the other direction and that the wheel is linked via a shaft in its axis of rotation to a part of an electric element, which preferably rotates for an unlimited angle.

In a first embodiment the casing is characterized in that a brake acts on the wheel by performing a different braking torque when rotating in one direction than in the other.

In a second embodiment the casing is characterized in that the wheel is toothed and in that a blocade acts on the toothed wheel, said blocade allowing rotation when opening the casing and preventing rotation in the reverse direction.

The casing of the invention of the first or second embodiment in the first variant is characterized in that the wheel is linked to a rotary panel of the trimmer capacitor via a shaft in its axis of rotation, said capacitor determining the common capacity in the oscillating circuit the casing is equipped with.

The casing of the invention of the first or second embodiment in the second variant is characterized in that the wheel is linked to a floating contact of an electric resistance via a shaft in its axis of rotation, said contact determining the resistance of an electrical resistor or the voltage on a part of it in relation to the wiring.

An arrangement of the casing of the invention to detect any opening even in the absence of a supply voltage is carried out in a simple and reliable manner with standard components.

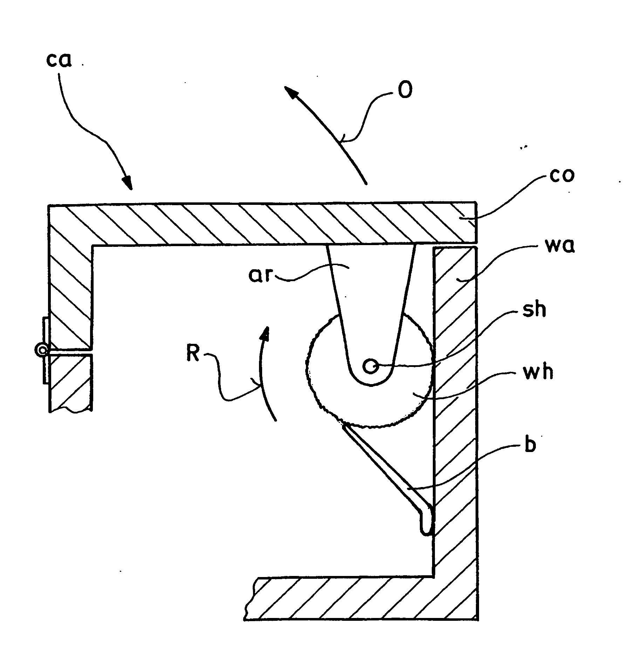

The invention will be described in more detail on the basis of a description of two embodiments and a corresponding single figure.

The casing ca of the invention is adapted to detect any opening O (Fig.). On a first part co of the casing ca, for instance on the cover co of the casing ca, an armature ar is arranged, in which a wheel wh is rotatingly arranged, said wheel rolling on the other part wa of the casing ca when the casing is being opened in the direction of R, for instance along the wall wa of the casing ca.

The wheel wh is linked via its shaft sh in its axis of rotation to a part of an electric element (not shown), said part being rotatable for an unlimited angle, for instance with a panel of a trimmer capacitor or a floating resistance contact.

According to the first embodiment of the casing of the invention a brake b acts on the wheel wh, so that said brake b performs a different braking torque on the wheel wh when rotating in one direction than when rotating in the other direction.

According to the second embodiment of the casing a blocade b acts on the wheel wh, said blocade allowing the wheel wh to rotate when the casing is being opened and preventing rotation in the opposite direction. Such casing allows the counting of casing openings in any known way.

The brake according to the first embodiment or the blocade according to the second embodiment make it impossible to repeat the position of the rotating part of the electric element after the casing has been closed again.

Either embodiment of the casing of the invention allows two possible variants.

According to the first variant, the wheel wh is linked via its shaft sh in its axis of rotation with a rotary panel of a trimmer capacitor. The capacitor determines the common capacity in the oscillating circuit (not shown), for instance in a RC oscillator arranged on the casing ca of the invention.

Said oscillating circuit is connected to a power supply of the means positioned inside the casing ca. The occurrence of a relative change (fn+1 - fn)/fn of the oscillating circle frequency, which is other than zero, between two consecutive periodical checkings of frequency, e.g. with a period of 1 second, is automatically reported to the supervisory location.

The oscillating circuit can be connected to a power supply source only in the process of checking. It is then established whether after the earlier procedure of checking a relative change (fn+1 - fn)/fn of the frequency of the oscillating circle occurred, said change not being zero.

The monitoring of the relative frequency change renders it possible to perform the oscillating circuit also with components of lower quality. The oscillating circle is preferably performed on the printed circuit of the means arranged within the casing of the device, i.e. with a resistor and a trimmer capacitor; due to the limitation of the frequency interval a ceramic capacitor can be added. Moreover, an AC/DC converter and a micro-controller can be added as well.

According to the second variant the wheel wh is connected with the movable contact of the electrical resistance via its shaft sh in its axis of rotation. The electrical quantity which in this variant provides the data on whether the casing of the invention has been opened or not, is either electric current if the floating contact is an intermediate contact, or electric power if the floating contact is either extreme resistance contact.

## Claims

1. Casing adapted to detect any opening, **characterized in that** on a first part (co) of the casing (ca) an armature (ar) is arranged, in which a wheel (wh) is rotatingly arranged, said wheel rolling on the other part (wa) of the casing (ca) when the first part (co) of the casing (ca) is being opened,
**in that** a means (b) acts on the wheel (wh), performing a different breaking torque on the wheel (wh) when rotating in one direction than when rotating in the other direction,
**in that** the wheel (wh) is linked to a rotating part of an electric element via a shaft (sh) in its axis of rotation.

2. Casing according to claim 1, **characterized in that** a said means comprise a brake (b) acting on the wheel (wh), said brake performing a different braking torque when rotating in one direction than when rotating in the other direction.

3. Casing according to claim 1, **characterized in that** the wheel is toothed and **in that** said means comprise a blocade (b) acting on the toothed wheel (wh), said blocade allowing the wheel (wh) to rotate when the casing is being opened and preventing a rotation in the opposite direction.

4. Casing according to claims 2 or 3, **characterized in that** the rotating part of the electric element is rotatable for an unlimited angle.

5. Casing according to one of the claims 2 to 4, **characterized in that** the wheel (wh) is linked to a rotary panel of a trimmer capacitor via a shaft (sh) in its axis of rotation, said capacitor defining the common capacity in the oscillating circuit with which the casing (ca) is equipped.

6. Casing according to one of the claims 2 to 4, **characterized in that** the wheel (wh) is connected to a floating contact of an electric resistor via the shaft (sh) in its axis of rotation, said resistor defining the resistance of the electric resistor or the voltage on one part of it.

## Patentansprüche

1. Gehäuse, welches zum Detektieren jedes Öffnens eingerichtet ist, **dadurch gekennzeichnet; dass** an einem ersten Teil (co) des Gehäuses (ca) ein Beschlag (ar) eingerichtet ist, in welchem ein Rad (wh) drehbar angeordnet ist, wobei das Rad auf dem anderen Teil (wa) des Gehäuses (ca) rollt, wenn der erste Teil (co) des Gehäuses (ca) geöffnet wird,
dass auf das Rad (wh) ein Mittel (b) einwirkt, welches ein anderes Bremsmoment auf das Rad (wh) ausübt, wenn es in die eine Richtung gedreht wird, als wenn es in die andere Richtung gedreht wird,
dass das Rad (wh) in seiner Drehachse über eine Welle (sh) mit einem drehbaren Teil eines Elektro-Elements verbunden ist.

2. Gehäuse gemäß Anspruch 1, **dadurch gekennzeichnet, dass** das Mittel eine Bremse (b) aufweist, welche auf das Rad (wh) einwirkt, wobei die Bremse ein anderes Bremsmoment ausübt, wenn es in die eine Richtung gedreht wird, als wenn es in die andere Richtung gedreht wird.

3. Gehäuse gemäß Anspruch 1, **dadurch gekennzeichnet, dass** das Rad gezahnt ist und dass das Mittel eine Sperre (b) aufweist, welche auf das gezahnte Rad (wh) wirkt, wobei die Sperre dem Rad (wh) zu drehen erlaubt, wenn das Gehäuse geöffnet wird, und eine Drehung in der entgegengesetzten Richtung verhindert.

4. Gehäuse gemäß Anspruch 2 oder 3, **dadurch gekennzeichnet, dass** der drehbare Teil des Elektro-Elements um einen unbegrenzten Winkel drehbar ist.

5. Gehäuse gemäß einem der Ansprüche 2 bis 4, **dadurch gekennzeichnet, dass** das Rad (wh) in seiner Drehachse über eine Welle (sh) mit einem Dreh-Paneel eines Abgleichkondensators verbunden ist, wobei der Kondensator die Gesamtkapazität in dem Schwingkreis definiert, mit welchem das Gehäuse (ca) versehen ist.

6. Gehäuse gemäß einem der Ansprüche 2 bis 4, **dadurch gekennzeichnet, dass** das Rad (wh) in seiner Drehachse über die Welle (sh) mit einem Gleitkontakt von einem Elektro-Widerstand verbunden ist, wobei der Widerstand den Widerstandswert des Elektro-Widerstandes oder die Spannung an einem Teil davon definiert.

## Revendications

1. Boîtier prévu pour détecter une ouverture quelconque, **caractérisé en ce que**, sur une première partie (co) du boîtier (ca) est disposée une armature (ar), dans laquelle une roue (wh) est disposée de façon rotative, ladite roue roulant sur l'autre partie (wa) du boîtier (ca) lorsque la première partie (co) du boîtier (ca) est ouverte,
**en ce que** des moyens (b) agissent sur la roue (wh), en exerçant un couple de freinage différent sur la roue (wh) quand elle tourne dans un sens et quand elle tourne dans l'autre sens,
**en ce que** la roue (wh) est liée à une partie rotative d'un élément électrique par l'intermédiaire d'un arbre (sh) dans son axe de rotation.

2. Boîtier selon la revendication 1, **caractérisé en ce que** lesdits moyens comportent un frein (b) agissant sur la roue (wh), ledit frein exerçant un couple de freinage différent lors de la rotation dans un sens et lors de la rotation dans l'autre sens.

3. Boîtier selon la revendication 1, **caractérisé en ce que** la roue est dentée et **en ce que** lesdits moyens comportent un blocage (b) agissant sur la roue dentée (wh), ledit blocage permettant à la roue (wh) de tourner lorsque le boîtier est ouvert et empêchant une rotation dans la direction opposée.

4. Boîtier selon les revendications 2 ou 3, **caractérisé en ce que** la partie rotative de l'élément électrique peut tourner sur un angle illimité.

5. Boîtier selon l'une des revendications 2 à 4, **caractérisé en ce que** la roue (wh) est liée à un panneau rotatif d'un condensateur variable par l'intermédiaire d'un arbre (sh) dans son axe de rotation, ledit condensateur définissant la capacité commune dans le circuit d'oscillation dont le boîtier (ca) est équipé.

6. Boîtier selon l'une des revendications 2 à 4, **caractérisé en ce que** la roue (wh) est reliée à un contact flottant d'une résistance électrique par l'intermédiaire de l'arbre (sh) dans son axe de rotation, ladite résistance définissant la résistance de la résistance électrique ou la tension sur une partie de celle-ci.
